(19) **Europäisches Patentamt**
**European Patent Office**
**Office européen des brevets**

(11) **EP 1 930 483 A1**

(12) **EUROPEAN PATENT APPLICATION**
published in accordance with Art. 153(4) EPC

(43) Date of publication:
**11.06.2008 Bulletin 2008/24**

(51) Int Cl.:
**C30B 29/06** *(2006.01)* **C01B 33/02** *(2006.01)*
**C30B 35/00** *(2006.01)*

(21) Application number: **05780341.3**

(22) Date of filing: **19.08.2005**

(86) International application number:
**PCT/JP2005/015132**

(87) International publication number:
**WO 2007/020706 (22.02.2007 Gazette 2007/08)**

(84) Designated Contracting States:
**DE FR**

(71) Applicant: **Sumco Solar Corporation**
**Kainan-shi**
**Wakayama 642-0001 (JP)**

(72) Inventor: **KANEKO, Kyojiro**
**Kainan-shi, Wakayama 642-0001 (JP)**

(74) Representative: **Bertsch, Florian Oliver et al**
**Kraus & Weisert,**
**Thomas-Wimmer-Ring 15**
**80539 München (DE)**

(54) **SILICON ELECTROMAGNETIC CASTING APPARATUS AND METHOD FOR OPERATING SAID APPARATUS**

(57)    An operation method of an electro-magnetic casting apparatus for silicon takes into account: the measurements of the surface temperature of the ingot and the temperature of the heating furnace; the control of the induction frequency for the electro-magnetic casting; the control of the power source output of the heating means based on the measured surface temperature of the solidified silicon; and the control of the induction frequency of induction power source based on the measured induction frequency of the induction coil power source; thus, it becomes possible to secure remarkable safety and productivity in the continuous casting of the silicon ingot, thereby enabling to facilitate the production of a semiconductor polycrystal silicon ingot, which is applied to safety operation widely.

FIG.8

EP 1 930 483 A1

**Description**

TECHNICAL FIELD

The present invention relates to a silicon electro-magnetic casting apparatus that manufactures a semiconductor polycrystal ingot, by applying an electro-magnetic casting technique using a circumferentially segmented and water-cooled conductive copper crucible (hereunder, referred to as 'cooling crucible'), and an operation method of executing the process control of a silicon electro-magnetic casting.

BACKGROUND ART

A continuous casting technique by the electro-magnetic induction (hereunder, referred to as 'electro-magnetic casting technique) does not allow a contact between a melted material and the crucible; and applying this technique to the casting of silicon will prevent silicon from contamination by impurities. And since there is not a contact between the melted material and the crucible, the life of the crucible can be prolonged; and since a mold for solidifying the melted material is not needed, the equipment investment can be reduced remarkably. In view of the crystallography, since the crystallization progresses from the bottom and side wall of the crucible, a directional solidification can easily be acquired. Therefore, the semiconductor polycrystal silicon ingot manufactured by the electro-magnetic casting technique is cut out into wafers, which are widely used as the substrate material of a silicon solar battery.

As having been proposed in the Japanese patent No. 2660225 (Aug.11th, 1988), the US patent No. 4915723 (Apl.10th, 1990), or the French patent application No. 00/06027 (May.11th, 2000), the electro-magnetic casting technique has been applied to the casting of silicon.

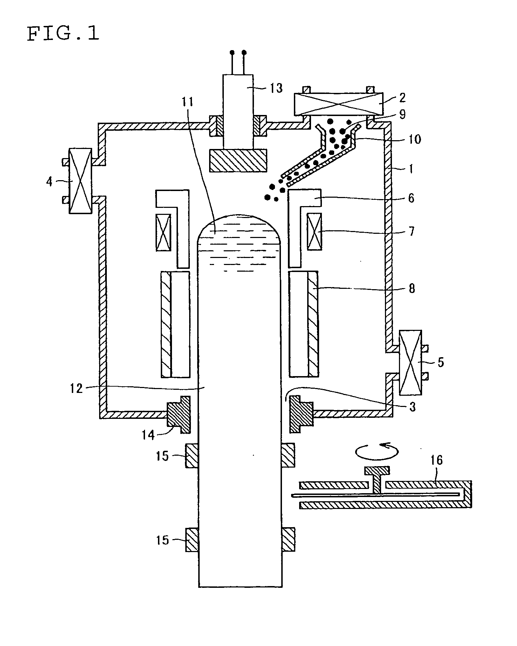

Fig. 1 illustrates a continuous casting method of a semiconductor polycrystal silicon ingot by the electro-magnetic casting technique. A chamber 1 is a double-wall water-cooling container to be protected from an internal generation of heat. The chamber 1 is coupled with a raw material charging device partitioned by a shielding means 2 on the top thereof, and has a withdrawal port 3 for pulling out the ingot on the bottom thereof. The chamber 1 is provided with an inert gas inlet port4 on the upper side wall thereof, and a vacuum evacuation port 5 on the lower side wall thereof.

In the central region of the chamber 1, there are provided a cooling crucible 6, an induction coil 7, and an after-heater (heating furnace for gradual cooling) 8 as the electro-magnetic casting means. The cooling crucible 6 with a water-cooling cylindrical body made of copper is circumferentially segmented into a plurality with the upper part being unsegmented. The induction coil 7 is mounted concentrically around the outer circumference of the cooling crucible 6, and is connected to a power supply by a coaxial cable not illustrated. The after-heater 8 is installed concentrically adjacent to and below the cooling crucible 6; and it heats the ingot pulled down from the cooling crucible 6 and gives a predetermined temperature gradient to the ingot in an axial direction thereof.

A raw material supply pipe 10 is installed below the shielding means 2 provided inside the chamber 1. A granular or lump silicon raw material 9 loaded into the raw material supply pipe 10 is supplied to a molten silicon 11 inside the cooling crucible 6. An auxiliary heater 13 made of graphite and so forth is disposed right on the top of the cooling crucible 6 so as to be movable upwardly/downwardly; and it is configured to be inserted into the inside of the cooling crucible 6 in a downward movement mode.

A gas seal 14 is provided below the after-heater 8, and a withdrawing device (a ingot holder) 15 that pulls out a silicon ingot 12 while supporting it is also provided below the after-heater 8. A diamond cutting machine 16 as a mechanical cutting means is provided outside the chamber 1 below the gas seal 14. The diamond cutting machine 16 is configured to be able to descend in a manner synchronized with a pulling-out speed of the silicon ingot 12. The diamond cutting machine 16 cuts the silicon ingot 12 being withdrawn outside the chamber 1 from the withdrawal port 3 while synchronizing with the movement thereof.

In the electro-magnetic casting of a semiconductor polycrystal silicon ingot, it becomes necessary to control the manufacturing processes more securely, more productively by automated operations. Concretely, in the electro-magnetic casting, the electro-magnetic pinching force allows to hold a molten silicon in a non-contact manner inside the segmented copper wall of the cooling crucible; therefore, it is most important to maintain the balance of the quantity of heat supply for melting and the electro-magnetic force for stably holding the melted material, and to avoid a sudden leakage of the molten silicon.

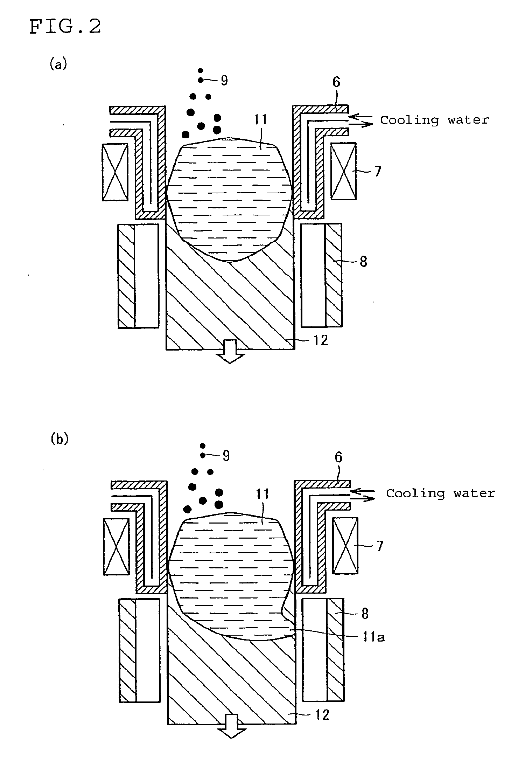

Fig. 2 illustrates the shape of a solid/liquid interface of the molten silicon, in which Fig. 2 (a) illustrates the shape of a solid/liquid interface in a stable casting state, and Fig. 2 (b) illustrates a breakout of the solid/liquid interface that has suddenly taken place. As shown in Fig. 2(b), in case a breakout 11a suddenly occurs, the molten silicon breaks a solidified side skin of the ingot at a lower part thereof outside the bottom of the crucible, which will trigger an outbreak of leakage.

Thus, if the molten silicon breaks the solidified side skin of the ingot at the lower part thereof outside the bottom of the cooling crucible, the casting operation will be interrupted inevitably. Such a sudden breakout of the molten silicon frequently occurs, when the temperature control of a gradual-cooling-purpose heating furnace (after-heater) located below the cooling crucible for gradually cooling the solidified ingot is inappropriate. Meanwhile, the difficulty in the temperature control of the gradual-cooling-purpose heating furnace (after-heater) is mainly caused by the fact that the shape of the solid/liquid interface of the molten silicon or the depth of the molten silicon cannot accurately be gauged.

Although there are the above problems, the conventional electro-magnetic casting of a silicon ingot has not adopted an effective means for controlling the casting securely and automatically. The means thus far adopted for operating the electro-magnetic casting of silicon is dependent only on the surface temperature measurement of an ingot and the temperature measurement of the gradual-cooling-purpose heating furnace; and the safe operation and the process control in the electro-magnetic casting of a silicon ingot are dependent on an operator proficient in the casting operation and the output control of a power supply.

DISCLOSURE OF THE INVENTION

The present invention intends to solve the above problems, and an abject of the invention is to provide an electro-magnetic casting apparatus and the method of operating the electro-magnetic casting for silicon that allows to controll the processes safely and automatically for continuously casting the silicon ingot, by virtue of not only limiting to the temperature measurements of an ingot surface and the heating furnace but also incorporating the measurement of induction frequencies in the electro-magnetic casting.

The inventors of the present invention performed various examinations for solving the above problems. The results clearly confirmed that the relation between the surface temperature of the ingot and the depth of the molten silicon in the electro-magnetic casting of a silicon ingot can be estimated by applying a thermal conductivity theory, and that the relation between the volume of the molten silicon and the induction frequency can be estimated by an electromagnetics theory. The contents of the above will be described by classifying them into several items.

(Relation between the surface temperature of the ingot and the depth of the molten silicon)

In the electro-magnetic casting system, the measurement of the surface temperature of the ingot is the basics of the process control for an appropriate continuous casting. Concretely, the surface temperature of the ingot is measured, and on the basis of the measured surface temperature, the temperature distribution inside the ingot can be determined by the thermal conductivity theory, thereby enabling to derive the electro-magnetic casting conditions. In an actual electro-magnetic casting, the surface temperature of the ingot is measured at the outlet of the crucible in the casting process, and the depth of the molten silicon is calculated on the basis of the thermal conductivity theory.

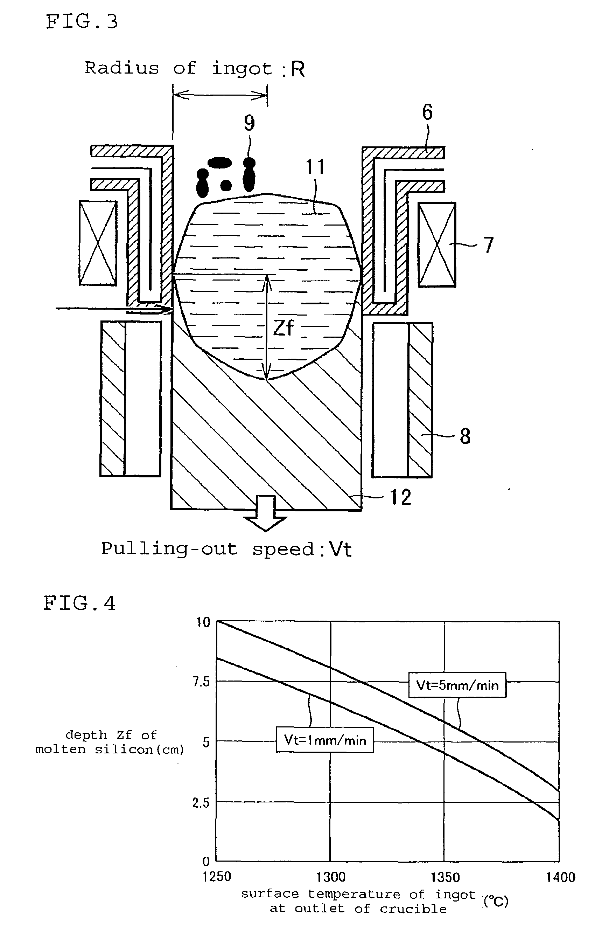

Fig. 3 illustrates one-dimensional model for analyzing the temperature distribution inside the silicon ingot being withdrawen at a withdrawing speed Vt. In the one-dimensional model illustrated in Fig. 3, the temperature distribution inside the silicon ingot in an axial direction in movement complies with the formula (1) to (3) described below. That is, as to a part of the ingot that is inside the cooling crucible, the temperature distribution is given by the formula (1) and (2); as to a part of the ingot that is outside the cooling crucible and inside the gradual-cooling-purpose heating furnace below the crucible, the temperature distribution is given by the formula (3).

[Formula 1]

$$\text{inside crucible: } 0 < z$$

$$\frac{d^2 T}{dz^2} + \frac{\rho \cdot Cp \cdot Vt}{\lambda} \cdot \frac{dT}{dz} - \frac{2 \cdot hi}{R \cdot \lambda} \cdot (T - Ti) = 0 \qquad \cdots \qquad (1)$$

$$\frac{d^2 T}{dz^2} + \frac{2 \cdot Pe}{R} \cdot \frac{dT}{dz} - \frac{2 \cdot Bi1}{R^2} \cdot (T - T1) = 0 \qquad \cdots \qquad (2)$$

[Formula 2]

```
outside crucible: z<0
```

$$\frac{d^2T}{dz^2} + \frac{2 \cdot Pe}{R} \cdot \frac{dT}{dz} - \frac{2 \cdot Bi2}{R^2} \cdot (T - T2) = 0 \qquad \cdots \qquad (3)$$

In the above formula (1) to (3), T represents the temperature, and z represents the distance along the axis. The other variables and the symbols relating to the physical properties of silicon and the numerals thereof are as follows.

R: Radius of silicon ingot (0.124m)
p: Density of silicon (2330kg/m$^3$)
Cp: Thermal capacity of silicon (1000J/kg·K)
Vt: Withdrawing speed of ingot (1.67-8.35x10$^{-5}$m/sec)
λ: Thermal conductivity of silicon (22W/m·K)
hi: Coefficient of heat exchange between surface of silicon ingot and crucible (320W/m$^2$·K)
hi2: Coefficient of heat exchange between surface of silicon ingot and periphery of furnace (70W/m$^2$·K)

Further, Pe represents Peclet Number in the formula (1) to (3) and there is a relationship of Pe=(R·Vt/2·Dth), where Dth= (λ/ρ·Cp). Similarly, Bi represents Biot Number, and there are relationships such as Bi=(hi·R/λ), Bi1=(hi·R/λ) and Bi2=(hi2·R/λ).

Yet further, T (m.p.) designates a melting point of silicon. As boundary conditions, T(z=Zf)=T(m.p.), T(z=0+)=T(z=0-), (dT/dz(0+))=(dT/dz(0-)) and T=T(z=-∞) in terms of z=-∞ are substituted, and thus the relation between the surface temperature T of the ingot at the outlet(z=0) of the cooling crucible and the depth Zf of the molten silicon (distance from the periphery of the solid/liquid interface) at a constant casting speed can be acquired.

Fig. 4 illustrates the relation between the surface temperature of the ingot at the outlet of the crucible and the depth of the molten silicon based on the analysis result. The result illustrated in Fig. 4 shows that, in case the withdrawing speed of the ingot is 5 mm/min, for example, when the surface temperature of the ingot at the outlet of the crucible is 1250 °C, the depth of the molten silicon is about 10 cm deeper than the level of the periphery of the solid/liquid interface.

On the other hand, it shows that, in case the withdrawing speed is 1 mm/min, when the surface temperature of the ingot at the outlet of the crucible is 1340 °C, the depth of the molten silicon is about 5 cm deeper than the level of the periphery of the solid/liquid interface. Thus, by measuring the surface temperature of the ingot at the outlet of the crucible in the electro-magnetic casting process, the shape of the solid/liquid interface of a silicon ingot can be grasped.

(Relation between the volume of the molten silicon and the induction frequency)

The induction frequency in an electric circuit is unique to each electric circuit. The induction frequency is determined by the condition of resonance of the alternate circuit, which is given by the following formula (4).

```
(2πf)²=ω²=1/(L•C)...(4)
```

where f is induction frequency, ω is resonance angle frequency, L is inductance and C is capacitance.

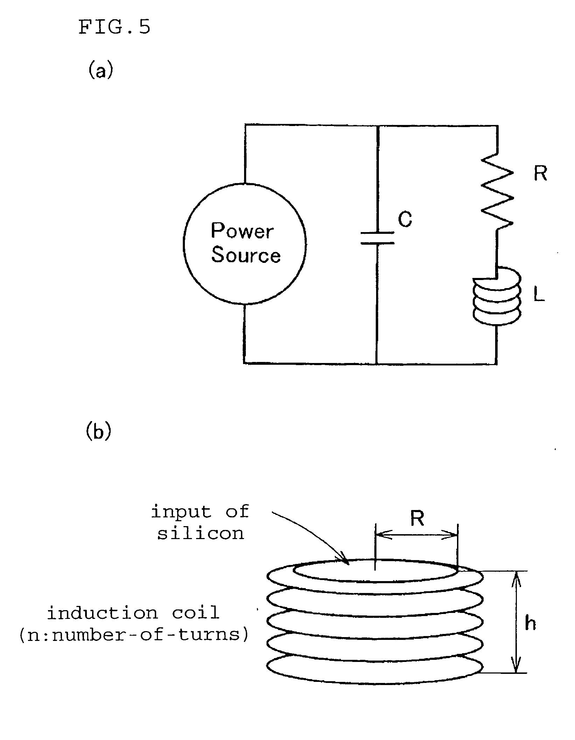

Fig. 5 (a) schematically illustrates the configuration of an equivalent circuit in the electro-magnetic casting. A power source, an electrical resistance R, an inductance L are constituents of the equivalent circuit in the electro-magnetic casting, and combining a condenser of some capacity to the circuit incorporates capacitance C of the circuit to compose the equivalent circuit.

Here, the inductance L in the electro-magnetic casting is composed of three-types of inductances. In concrete, it is composed of a coil inductance L (coil), a crucible inductance L (crucible), and a raw material inductance L (raw material) to which the melted material contributes, as shown by the following formula (5).

```
L=L(coil)+L(crucible)+L(raw material)...(5)
```

In the formula (5), since the coil inductance L (coil) and the crucible inductance L (crucible) are built in the casting apparatus, these inductances are constant. However, the raw material inductance L (raw material) greatly varies depending on the quantity of the molten silicon and the depth and shape of melted silicon.

Fig. 5(b) illustrates how the raw material inductance L (raw material) varies in association with charging of silicon. The diagram schematically illustrates the components of a coil radius R, a coil number-of-turns n, and a coil height h that give influences to the raw material inductance L (raw material) in association with charging of silicon, in terms of the electromagnetics.

The raw material inductance L (raw material) remarkably varies when the depth of the molten silicon varies in association with charging of silicon. Generally, metals show substantially the same electrical resistances in both states of solid and liquid; however, the electrical resistance of silicon in the molten state is decreased to about 1/70 of that in the solid state, and the variation thereof is significant. Accordingly, as the volume of the molten silicon increases, the electric current distribution flowing through the silicon varies, thus leading to variations of the inductance.

For the variations of the raw material inductance L (raw material) in association with charging of silicon, the self-inductance can be estimated by the following formula (6), based on the elecromagnetics theory.

$$L(Raw\ material) = \pi \cdot R^2 \cdot n^2 \cdot \mu_0 \cdot h \cdot K(R,h) \ldots (6)$$

where R is a coil radius, n is the number of turns in coil, $\mu_0$ is a vacuum magnetic permeability, h is a coil height and K (R, h) is a Nagaoka coefficient.

In the configuration illustrated in Fig. 5(b), the raw material inductance L (raw material) by the variations of the depth of the molten silicon residing within the range of the coil can approximately be calculated as below. Where the construction of molten silicon is set under the conditions of R=0.124m, n=1 (the number of turns), $\mu\mu\mu_0 = 4\pi \cdot 10^{-7}$N/A$^2$, and K(R,h)≈1, the raw material inductance L (raw material) accompanied with the variations of the depth of the molten silicon is as follows.

When h=10cm, L(raw material)=1.52x10$^{-7}$H.
When h=20cm, L(raw material)=3.04x10$^{-7}$H.
When h=30cm, L(raw material)=4.55x10$^{-7}$H.

Provided the raw material inductance L (raw material) accompanied with the variations of the depth of the molten silicon can be calculated as above, the variations of the induction frequency in the equivalent circuit, influenced by the depth of the molten silicon, can be estimated. In the apparatus illustrated in the embodiment described later, when the electro-magnetic casting of a silicon ingot was performed according to the normal operation, under the conditions that the depth of the molten silicon h be 20 cm, the electrical capacitance in the equivalent circuit was 18.5 $\mu$F, and the induction frequency thereat was 15, 879 Hz. When these measured values were substituted in the formula (4), the total inductance at h = 20 cm was 5.430 $\mu$H.

From the total inductance at h = 20 cm acquired as above, the variations of the total inductance at h = 10 cm and h = 30 cm can be calculated by using the raw material inductance L (raw material) estimated as above. Thereby, the induction frequencies at h = 10 cm and h = 30 cm are estimated as follows. When h=10cm, L=5.582x10$^{-6}$H, hence f=15,661Hz.

When h=20cm, L=5.430x10$^{-6}$H, hence f=15,879Hz.
When h=30cm, L=5.279x10$^{-6}$H, hence f=16,105Hz.

According to the above estimation, if the depth variation of the molten silicon gets deeper or shallower by tens of centimeter from the normal casting condition (h = 20 cm), the variation of the induction frequency is estimated to amount to hundreds of Herz(Hz).

As to the measurement accuracy of the induction frequency at present, approximately $\pm$1 Hz can be secured; therefore, by measuring the variation of the induction frequency at an electro-magnetic casting, it is possible to estimate the depth of the molten silicon. Therefore, in controlling the electro-magnetic casting of a silicon ingot, it becomes an effective process control means to acquire information for estimating the depth of the molten silicon based on the measurement result of the induction frequency.

The present invention has been made based on the above findings, and the essentials thereof are the following: (1) a silicon electro-magnetic casting apparatus, and (2) an operation method of the same.

(1) A silicon electro-magnetic casting apparatus that pulls down a molten silicon melted by an electro-magnetic induction and solidifies the molten silicon, being provided with: a conductive cooling crucible at least a part of which in an axial direction is segmented circumferentially into a plurality; an induction coil surrounding the crucible; and a heating means located below the crucible for gradually cooling the solidified silicon, the electro-magnetic casting apparatus comprising: a means for measuring a surface temperature of the solidified silicon at an outlet of the cooling crucible; a means for measuring an induction frequency of an induction power source of the induction coil; a means for controlling a power source output of the heating means, based on the measurement of the surface temperature of the solidified silicon; and a means for controlling an output of the induction power source, based on the measurement of the induction frequency.

(2) An operation method of the silicon electro-magnetic casting apparatus that pulls down a molten silicon melted by an electro-magnetic induction and solidifies the molten silicon, being provided with: a conductive cooling crucible at least a part of which in an axial direction is segmented circumferentially into a plurality; an induction coil surrounding the crucible; and a heating means located below the crucible for gradually cooling the solidified silicon, the method comprising the steps of: measuring a surface temperature of the solidified silicon at an outlet of the cooling crucible; controlling a power source output of the heating means thereafter, based on the measurement result of the surface temperature of the solidified silicon in contradistinction to a preset target surface temperature; measuring an induction frequency of an induction power source of the induction coil at the same time ; and controlling an output of the induction power source thereafter, based on the measurement result of the induction frequency in contradistinction to a preset target induction frequency.

In the operation method according to the present invention, it is preferable to control the power source output of the heating means and the induction frequency of the induction power source, based on the most immediate three-times-measurements, even when the measurements of the surface temperature of the solidified silicon and the induction frequency are within the preset target ranges.

BRIEF DESCRIPTION OF THE DRAWINGS

Fig. 1 is a diagram illustrating a continuous casting method of a semiconductor polycrystal silicon ingot by the electro-magnetic casting technique;

Fig. 2 is a diagram illustrating the shape of a solid/liquid interface of the molten silicon, in which Fig. 2 (a) illustrates the shape of a solid/liquid interface in a stable casting state, and Fig. 2(b) illustrates a breakout of the solid/liquid interface that suddenly occurs;

Fig. 3 is a diagram illustrating one-dimensional model for analyzing the temperature distribution inside the silicon ingot being withdrawn downwardly at a withdrawing speed Vt;

Fig. 4 is a diagram illustrating the relation between the surface temperature of the ingot at the outlet of the cooling crucible and the depth of the molten silicon based on the analysis;

Fig. 5 is a diagram schematically illustrating the electrical configuration in the electro-magnetic casting, in which Fig. 5 (a) schematically illustrates the configuration of an equivalent circuit in the electro-magnetic casting, and Fig. 5 (b) illustrates an inductance L in a melted raw material which is reflected by a melting coil, a cooling crucible, and melting in association with charging of silicon;

Fig. 6 is a diagram illustrating the variations of the induction frequency and the surface temperature of the silicon when the depth of the molten silicon varies;

Fig. 7 is a diagram illustrating a measured result of the depth of the molten silicon, the induction frequency, and the surface temperature of the ingot, under the conditions (1) to (4) illustrated in Fig. 6;

Fig. 8 is a diagram illustrating the relation between input parameters and output parameters, which becomes necessary for the process control of the electro-magnetic casting;

Fig. 9 is a flow chart illustrating the basic configuration of the process control of the electro-magnetic casting;

Fig. 10 is a diagram illustrating how a process control effects in the embodiment 1;

Fig. 11 is a flow chart for improving the process control of the electro-magnetic casting adopted in the embodiment 2; and

Fig. 12 is a diagram illustrating how a process control effects in the embodiment 2.

BEST MODE FOR CARRYING OUT THE INVENTION

Hereunder, the present invention will be described, being classified into the following three areas: "the construction of an electro-magnetic casting apparatus and the operation method of the apparatus", "the influence that the depth of the molten silicon exerts on the induction frequency and the surface temperature of the silicon", and "the parameters of the process control and the basic configuration of the process control"

1. Construction of an electro-magnetic casting apparatus and the operation method of the same.

Using an apparatus construction in Fig. 1, the construction of an electro-magnetic casting apparatus and the operation method of the apparatus will be described. The inventors of the present invention prepared an airtight cylindrical chamber 1 having a diameter of 1.2 m and a height of 2.8 m, and an apparatus for electro-magnetically melting a semiconductor silicon which is charged inside the chamber 1, in order to manufacture an ingot 12 with a cross-section of 22 cm × 22 cm and a length of 2.0 m.
The height of the cooling crucible 6 was 55 cm, the segment length of which was 45 cm, and the wall thickness of which was 2.7 cm. Around the periphery of the cooling crucible 6 was located an induction coil 7 having an internal dimension of 30 cm × 30 cm and a height of 13 cm, which is connected to a high-frequency induction power source (not illustrated) being capable of outputting 350 kW max at approximately 15 kHz.
For starting the electro-magnetic casting, as an initial charging material, a semiconductor silicon block 9 having a cross-section of 21 cm × 21 cm, a height of 10 cm, and an electric resistivity of $1\Omega\cdot$cm was charged into the cooling crucible disposed on a graphite pedestal. The bottom height of the silicon block 9 was set to the height of the lower end of the induction coil 7.
Next, the auxiliary heater 13 located above the cooling crucible 6 was lowered to such a level that is away by 2 cm from the top surface of the semiconductor silicon block 9 charged into the cooling crucible 6. The auxiliary heater 13 is made of a graphite resistance heater, to which an electric current is supplied from a 50-Hz transformer that is widely used. Next, an electric current was supplied to the auxiliary heater 13 which provides radiating heat onto the upper portion of the silicon block 9 to reach about 600 °C.
The temperature of the upper portion of the silicon block 9 heated by the auxiliary heater 13 reached about 650 °C after about 20 minutes; thereafter, the induction heating device started heating the solid silicon. Next, the auxiliary heater 13 was switched off, and moved to the uppermost position in the cooling crucible 6. As the output of the induction heating device was gradually increased to 300 kW in about 20 minutes, the silicon block 9 inside the cooling crucible 6 started melting from the periphery portion.
The silicon block 9 was completely melted after about 20 minutes, and a granular silicon material 9 was charged into the cooling crucible 6 from the shielding means 2. The height of the molten silicon 11 increased in association with the silicon material 9 being charged, and when the height of the molten silicon 11 reached the upper end level of the coil 7, the graphite pedestal begins to move downward for starting solidification of the ingot.
The electro-magnetic casting was continued until the length of the ingot 12 was grown to 200 cm. At the beginning, the casting speed was maintained at 2 mm/min. Thereby, the casting continued for about 15 hours. When the length of the ingot 12 was grown to 200 cm, the supply of the silicon material 9 was halted, and the downward movement speed of the ingot holder 15 was decreased to be slow.
The auxiliary heater 13 was again lowered to such a level that is away by about 3 cm from the top surface of the molten silicon 11, and was switched on to heat it to about 1600 °C. The auxiliary heater 13 functioned as a hot top for heating the upper part of the molten silicon 11. By gradually decreasing the current from the induction power source, and then gradually lowering the output of the auxiliary heater 13, the entire ingot 12 was solidified. After the solidification was completed, the downward movement of the ingot 12 was stopped.

2. Influence of the depth of the molten silicon on both the induction frequency and the surface temperature of the silicon.

An experiment was made to investigate the influence of the variation of the depth of the molten silicon on both the induction frequency and the surface temperature of the silicon using the structure of electro-magnetic casting apparatus according to the present invention in Fig.1.

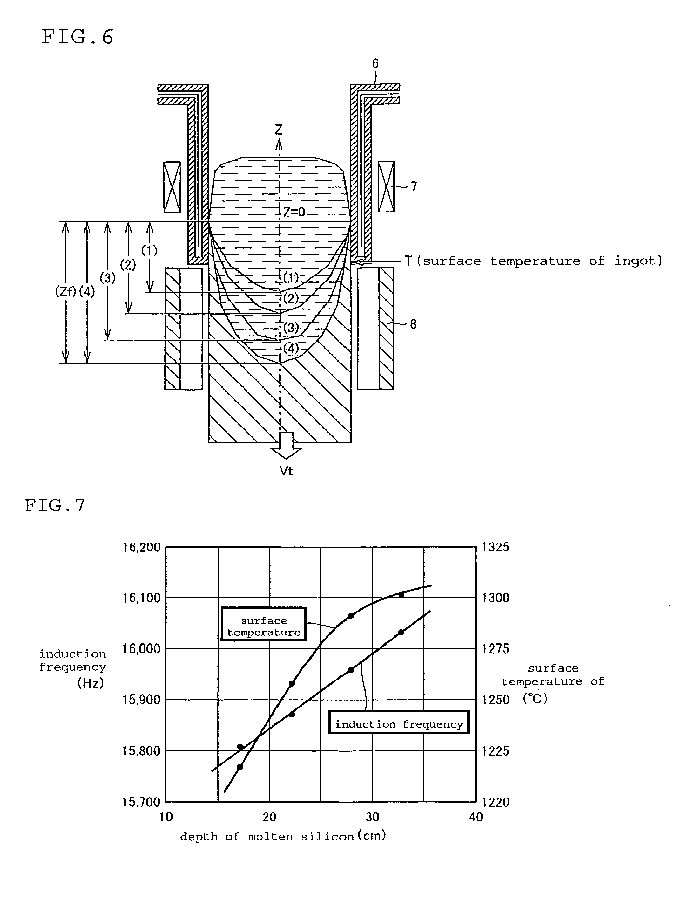

Fig. 6 illustrates the procedure of assessing the influence on both the induction frequency and the surface temperature of the silicon, when the depth of the molten silicon varies. As illustrated in the diagram, the induction frequency and the surface temperature of the ingot at the bottom outlet of the cooling crucible were measured when the depth Zf of the molten silicon varied as (1) to (4) illustrated in the diagram.
The casting speed Vt during measurement was 2 mm/min. In a state that the casting became stable after 7 hours passed from the start of casting, a graphite rod with a length of 1.5 m and a diameter of 2 cm was inserted into the inside of the apparatus, and the distance until the graphite rod reached the bottom of the molten silicon was measured. Since the graphite rod soaked into the molten silicon generates a difference in gloss of surface, the soaked length becomes discernible; thereby, the depth of the molten silicon can be measured. Here, the induction frequency and the surface temperature of the ingot at the outlet of the crucible were measured at the same time as measuring the soaked length of the graphite rod.
Under the condition (1) illustrated in Fig. 6, after measuring the depth of the molten silicon, the induction frequency, and the surface temperature of the ingot, the output of the induction power source were increased. After continuing the casting under the same operational condition as above for a while to reach the steady state, the depth of the molten silicon, the induction frequency, and the surface temperature of the ingot were measured under the condition (2) illustrated in Fig. 6. The same operations were repeated, so that the depth of the molten silicon, the induction frequency, and the surface temperature of the ingot were measured under the conditions (3), (4) as illustrated in Fig. 6.

Fig. 7 illustrates measured results of the depth of the molten silicon, the induction frequency, and the surface temperature of the ingot under the conditions (1) to (4) as illustrated in Fig. 6. The measured depth of the molten silicon varied from 17 cm to 33 cm, the variation of which was 16 cm. The measured induction frequency varied from 15, 802 Hz to 16, 024 Hz, the variation of which was 222 Hz. And the measured surface temperature of the ingot varied from 1218 °C to 1304 °C, the variation of which was 86 °C.

When the measurement results illustrated in Fig. 7 are compared with the above calculation results, the variation of the measured induction frequency in association with the variation of the depth of the molten silicon was shown to be significantly small compared to the variation by the calculation result in the same condition. The reason is considered such that the calculation of the frequency is based on a simplified model that takes into account only the variation of the coefficient of self-induction without taking into account the variation of the coefficient of mutual induction. In the same manner, the variation of the surface temperature of the ingot at the outlet of the crucible in association with the variation of the depth of the molten silicon was small compared to the calculated variation under the same condition. Such discrepancies are conceivably caused by either the simplified model and the actual boundary conditions which are not correctly incorporated into the calculation, and so forth.

However, it was verified in the electro-magnetic casting process that the variations of the measured induction frequency and the measured surface temperature of the ingot in association with the variation of the depth of the molten silicon were appreciably large, compared to the measurement accuracy. Thus, the basic technical philosophy of the present invention, that is, the concept of the process control was clarified to be practically effective. In concrete, the measurement accuracy of the induction frequency by a measuring device presently available is about $\pm$ 1 Hz, and the measurement accuracy of the surface temperature of the ingot is as good as less than $\pm$ 1 °C. Thus, it is sufficiently possible to grasp the variation of the depth of the molten silicon.

3. Parameters of the process control and the basic configuration of the process control.

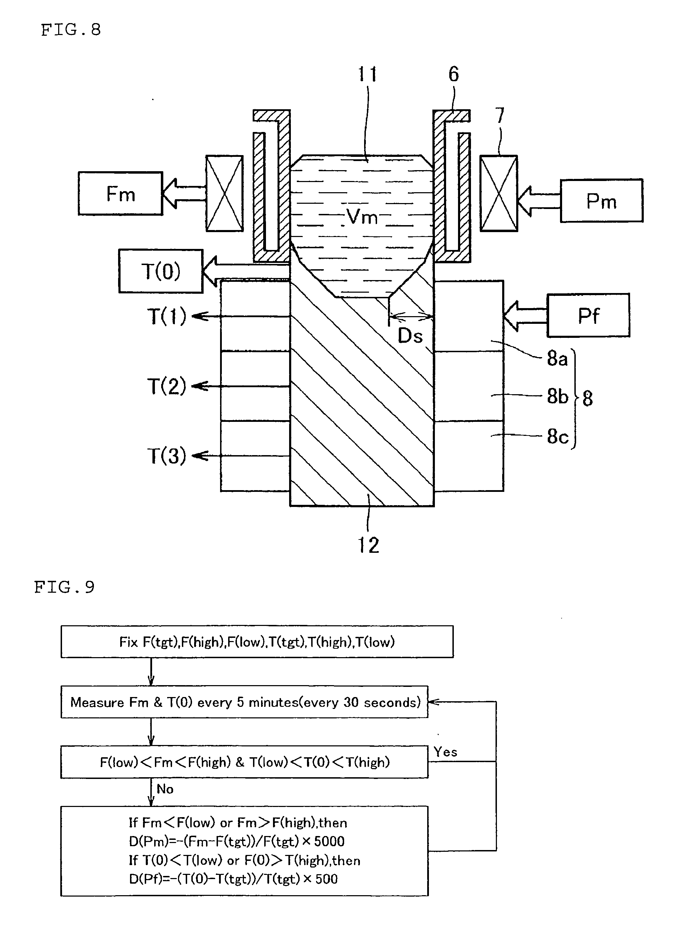

Fig. 8 illustrates the relation between input parameters and output parameters, which becomes necessary for the process control of the electro-magnetic casting. In the embodiment according to the present invention, the induction frequency of the equivalent circuit was adopted as the frequency, and the surface temperature of the ingot at the outlet of the cooling crucible was adopted as the temperature. The heating furnace for gradual cooling 8 (after-heater) disposed below the cooling crucible was classified into a first heating furnace 8a, a second heating furnace 8b, and a third heating furnace 8c.

As illustrated in Fig. 8, the principal output parameters in the process control of the electro-magnetic casting are the induction frequency Fm and the surface temperature T (0) of the ingot at the outlet of the crucible. On the other hand, the principal input parameters in the process control are the output Pm of the induction power source and the output Pf of the first heating furnace power source.

As the other parameters, the temperature T (1) of the first heating furnace, the temperature T (2) of the second heating furnace, the temperature T (3) of the third heating furnace, the volume Vm of the molten silicon, and the thickness Ds of a solidified shell are illustrated in Fig. 8.

Fig. 9 is a flow chart illustrating the basic configuration of the process control of the electro-magnetic casting. The process control illustrated in Fig. 9 is a computing system, and the input parameters are the induction frequency Fm and the surface temperature T (0) of the ingot at the outlet of the crucible. And the output parameters are the output variation D (Pm) of the induction power source and the variation D (Pf) of the first heating furnace power source.

As illustrated in the flow chart in Fig. 9, the following values are preset: target induction frequency F (tgt), upper limit induction frequency F (high), lower limit induction frequency F (low), target surface temperature of the ingot T (tgt), upper limit surface temperature of the ingot T (high), and lower limit surface temperature of the ingot T (low).

As the casting gets started, the overall power consisted of the output Pm of the induction power source and the output Pf of the first heating furnace power source is supplied to the electro-magnetic casting system in accordance with the charging speed of the silicon material. These power outputs are monitored as the input variables of the computing system, and are recorded periodically. In the flow chart illustrated in Fig. 9, the induction frequency Fm of the equivalent circuit and the surface temperature T (0) of the ingot at the outlet of the cooling crucible are monitored at an interval of 30 seconds to 5 minutes as the input variables of the computing system.

The computing system stays as it is, if the input induction frequency Fm and surface temperature T (0) of the ingot are between the upper limit values and the lower limit values of each. And if the input induction frequency Fm and surface temperature T (0) of the ingot should exceed the upper limit values or the lower limit values of each, the output Pm of the induction power source or the output Pf of the first heating furnace power source is modified. And if both the values should exceed the limit values, both are modified.

As an example of the operation method, if the input induction frequency Fm should exceed the upper limit or the lower limit, the output variation D (Pm) of the power source will be determined by the following formula (7).

$$D(Pm) = -\{Fm - F(tgt)\}/F(tgt) \times 5000 ... (7)$$

On the other hand, if the input surface temperature T (0) of the ingot should exceed the upper limit or the lower limit, the output D (Pf) of the first heating furnace power source will be determined by the following formula (8).

$$D(Pf) = -\{T(0) - T(tgt)\}/T(tgt) \times 500 ... (8)$$

Thus, in the process control of the electro-magnetic casting according to the present invention, looping back data processing enables to perform the automated process control in the electro-magnetic casting of silicon.

[Embodiments]

(Embodiment 1)

As the embodiment 1 according to the present invention, the electro-magnetic casting of silicon was performed by using the electro-magnetic casting apparatus illustrated in Fig. 1. As mentioned above, the apparatus that performs the electro-magnetic casting of an ingot with a cross-section of 22 cm × 22 cm has the following construction: the internal dimension and external dimensions of the cooling crucible are 22 cm × 22 cm and 27.4 cm × 27.4 cm respectively, the height of the crucible is 55 cm, the vertical length of the segmented portion of the crucible is 45 cm, and the electrical induction coil having an internal dimension of 30 cm × 30 cm and a height of 13 cm is located around the periphery of the crucible.
The maximum output of the induction power supply is 350 kW, which was connected to the induction coil inside the storage chamber. The total capacitance of the electric circuit amounts to 18.5 μF, and the total induction inductance under the normal casting condition was set to 5.430 μH as already mentioned.
In order to control the cooling temperature of the ingot that is being solidified, the after-heater system was built up with a three-stage heating furnace for gradual cooling located below the outlet of the cooling crucible. The height of the furnace of each stage was 25 cm, and an electric resistance heater of graphite or molybdenum, having the maximum output power 30 kW is used for the furnace. Further, the process control computing system was linked with a measuring device of the induction frequency and the surface temperature of the ingot, and the output control of the induction power source and the heating furnace power source was performed.
Starting the electro-magnetic casting, and when it reached a stable operating state, the process control was executed based on the flow chart illustrated in Fig. 9. At the withdrawing speed of the ingot Vt 2 mm/min, the output of the induction power source was set in a range of 190 to 225 kW and the output of the first stage heating furnace power source for gradual cooling was set in the range of 15 to 20 kW under a stable casting operation. The target induction frequency F (tgt) was set to 15, 879 Hz, and the target surface temperature of the ingot T (tgt) at the outlet of the crucible was set to 1257 °C. The upper limit induction frequency F (high) was set to 15, 887 Hz, and the lower limit induction frequency F (low) was set to 15, 871 Hz. The upper limit surface temperature of the ingot T (high) was set to 1260 °C, and the lower limit surface temperature of the ingot T (low) was set to 1254 °C.
The induction frequency Fm and the surface temperature T (0) of the ingot were input from the measuring device to the process control computer every 30 seconds, and the operations based on the input measured values were executed. When both of the input induction frequency Fm and the surface temperature T (0) of the ingot are between the upper and lower limit values, the computer system waits for the next inputs from the measuring device.
On the other hand, when either of the input induction frequency Fm and surface temperature T (0) of the ingot exceeds the upper limit values or decreases from the lower limit values, the output Pm of the induction power source or the output Pf of the first heating furnace power source is modified. And when both the values exceed the limit values, both are modified.
In other words, when the input induction frequency Fm exceeded the upper limit value or the lower limit value, the output variation D (Pm) of the power source was determined by the following formula (7).

$$D(Pm) = -\{Fm - F(tgt)\}/F(tgt) \times 5000(kW)...(7)$$

On the other hand, when the input surface temperature T (0) of the ingot exceeded the upper limit value or the lower limit value, the output variation D (Pf) of the first heating furnace power source was determined by the following formula (8).

$$D(Pf) = -\{T(0) - T(tgt)\}/T(tgt) \times 500(kW)...(8)$$

As an example of the process control, when the measured value of the induction frequency Fm is 15,869 Hz, the output variation D (Pm) of the power source is 3.1 kW to the induction power source, based on the formula (7). On the other hand, when the measured value of the surface temperature T (0) of the ingot is 1261 °C, the output variation D (Pf) of the first heating furnace power source is -1.6 kW to the heating furnace power source.
The computer process control was continued until the length of the ingot was grown to 200 cm and the supply of silicon raw material was completed.

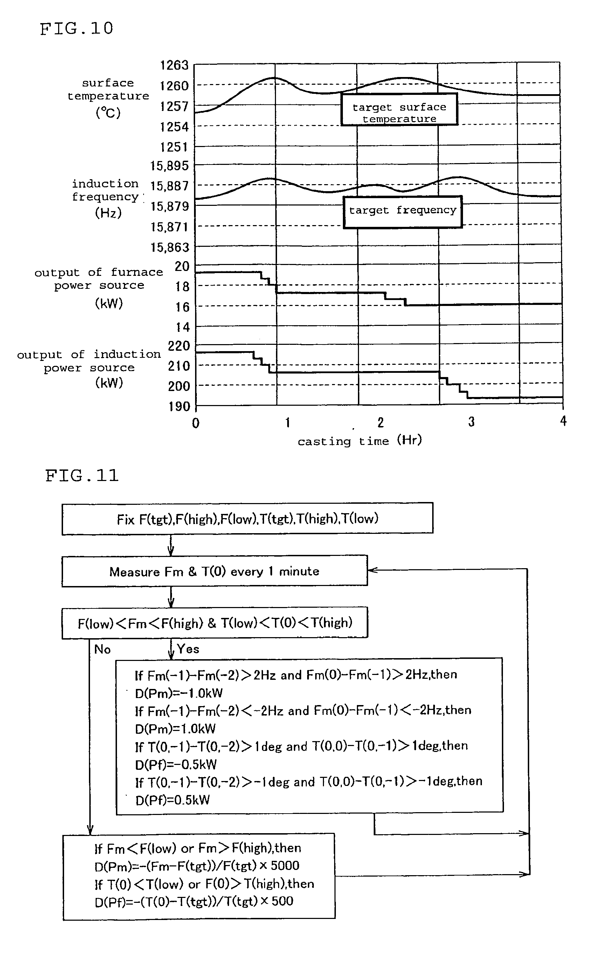

Fig. 10 illustrates how the process control effects in the embodiment 1. The state of the process control illustrated in Fig. 10 shows the variations of the surface temperature of the ingot and the induction frequency while casting time elapses. As shown in the diagram, the operation of the electro-magnetic casting advanced smoothly and automatically from the start of the control till the end of the control, reaching the completion of material supply.
In the process control illustrated in Fig. 10, the surface temperature of the ingot at the outlet of the crucible and the induction frequency gradually increased for the first hour. Next, as the output power source started to gradually decrease, the temperature as well as the induction frequency decreased, and the surface temperature of the ingot and the induction frequency gradually approached the target levels.
Thereafter, the surface temperature of the ingot and the induction frequency had hardly varied until the casting ended. This embodiment 1 verified that the electro-magnetic casting of a silicon ingot can be implemented by the basic configuration of the process control illustrated in Fig. 9.

(Embodiment 2)

The embodiment 2 according to the present invention exhibited a higher-accuracy output control of the power source. Even when the induction frequency and the surface temperature of the ingot each were within the upper limit and the lower limit, the output of the power source was varied based on the variation of the most immediate input values.
Fig. 11 is a flow chart for improving the process control of the electro-magnetic casting adopted in the embodiment 2. Here, in addition to the definition of the terminologies used in Fig. 9, the following are defined: the induction frequency Fm (0) as an input this time, the induction frequency Fm (-1) as an input last time, and the induction frequency Fm (-2) as an input before last; the surface temperature T (0, 0) of the ingot as an input this time, the surface temperature T (0, -1) of the ingot as an input last time, and the surface temperature T (0, -2) of the ingot as an input before last.
The construction of the apparatus for casting a silicon ingot with a cross-section of 22 cm $\times$ 22 cm is the same as that in the embodiment 1, that is, the internal dimension of the cooling crucible was 22 cm $\times$ 22 cm, the internal dimension of the induction coil was 30 cm $\times$ 30 cm, and so forth. Further, the total capacitance 18.5 $\mu$F and the total induction inductance 5.430 $\mu$H under the normal casting condition were set as being the same as the embodiment 1.
After about one hour passed from starting the electro-magnetic casting of silicon, the casting reached substantially the steady state of operation; thereafter, the process control was executed based on the flow chart illustrated in Fig. 11. While the control maintained the withdrawing speed of the ingot at 2 mm/min, the output variation of the induction power source was within 190 to 225 kW and the output of the heating furnace power source was within 15 to 20 kW. The target induction frequency F (tgt) was set to 15, 879 Hz, and the target surface temperature of the ingot T (tgt) was set to 1257 °C. In the same manner as the embodiment 1, the upper limit induction frequency F (high) was set to 15,887 Hz, and the lower limit induction frequency F (low) to 15,871 Hz; the upper limit surface temperature of the ingot T (high) to 1260 °C, and the lower limit surface temperature of the ingot T (low) to 1254 °C.
The induction frequency Fm and the surface temperature T (0) of the ingot were measured every one minute. When the induction frequency Fm and the surface temperature T (0) of the ingot are within the thresholds of the upper limits and the lower limits of each, the condition of varying the power supply output was controlled as the following (1), (2), based on the most immediate input measured values.

(1) Case where comparing the induction frequency Fm (0) as an input this time, the induction frequency Fm (-1) as an input last time, and the induction frequency Fm (-2) as an input before last: When {Fm(-1)-Fm(-2)}>2Hz and {F(0)-F(-1)}>2Hz, the output variation D(Pm) of power source is -1.0kW.

When {Fm(-1)-Fm(-2)}<-2Hz and {F(0)-F(-1)}<-2Hz, the output variation D(Pm) of power source is 1.0kW.

(2) Case where comparing the surface temperature T (0, 0) of the ingot as an input this time, the surface temperature T (0, -1) of the ingot as an input last time, and the surface temperature T (0, -2) of the ingot as an input before last:

When {T(0,-1)-T(0,-2)}>1°C and {T(0,0)-T(0,-1)}>1°C, the output variation D(Pf) of first heating furnace power source is -0.5kW.

When {T(0,-1)-T(0,-2)}<-1°C and {T(0,0)-T(0,-1)}<-1°C, the output variation D(Pf) of first heating furnace power source is 0.5kW.

In case that the variations of the most immediate input values are outside the above, when the increase or decrease of the input measured values by 4 Hz in induction frequency or by 2°C in surface temperature of ingot continues for 5 minutes, the output of the induction power source or the output of the heating furnace power source is modified by 1.0 kW or 0.5 kW so as to suppress the variation.

In other words, when the most immediate input induction frequency continues to increase by more than 4 Hz for 5 minutes, the output of the power source is decreased by 1.0 kW. On the other hand, when the most immediate input surface temperature of the ingot continues to decrease by more than 2°C for 5 minutes, the output of the heating furnace power source is increased by 0.5 kW.

On the other hand, when the input induction frequency Fm and the input surface temperature T (0) of the ingot become to exceed the upper limits or the lower limits of each, the output Pm of the induction power source or the output Pf of the first heating furnace power supply is modified. And when both values of the former two exceed the limits, both of the latter two are modified.

In other words, when the input induction frequency Fm exceeded the upper limit value or the lower limit value, the output variation D (Pm) of the power source was determined by the following formula (7).

On the other hand, when the input surface temperature T (0) of the ingot exceeded the thresholds of the upper limit value or the lower limit value, the output variation D (Pf) of the first heating furnace power source was determined by the following formula (8).

The determination of the output variation D (Pm) of the power source based on the formula (7) and the determination of the output variation D (Pf) of the first furnace power source based on the formula (8) are the same as the embodiment 1.

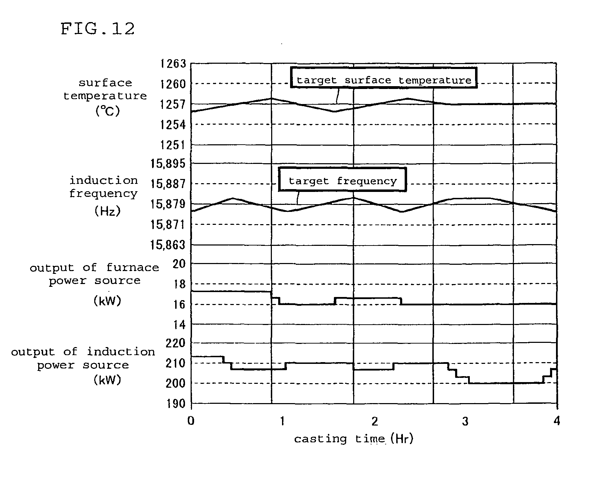

Fig. 12 illustrates how the process control effects in the embodiment 2. The state of the process control illustrated in Fig. 12 is shown by the variations of the surface temperature of the ingot and the induction frequency during casting time elapses. The computer process control was continued until the length of the ingot was grown to 200 cm and the supply of silicon raw material was completed; as shown in Fig. 12, the electro-magnetic casting advanced smoothly automatically, in the casting operation from the start of the control to the completion of material supply.

As described in the embodiment 1, 2, the process control according to the present invention is effective and applicable in the electro-magnetic casting of a silicon ingot. And, as useful parameters for the process control, it is necessary to control the induction frequency and the surface temperature of the ingot at the outlet of the crucible. By using these as the parameters, it was proved that the electro-magnetic casting of a silicon ingot can be implemented while securing remarkable safety and productivity.

INDUSTRIAL APPLICABILITY

The electro-magnetic casting apparatus for a silicon ingot of the present invention and the operation method of the same, taking into account not only the measurements of the surface temperature of the ingot and the temperature of the heating furnace, but also the control of the induction frequency for the electro-magnetic casting, controls the power source output of the heating means based on the measured surface temperature of the solidified silicon as well as controls the electrical induction frequency based on the measured induction frequency; thereby, it becomes possible to secure remarkable safety and productivity in the continuous casting of the silicon ingot, and to facilitate the production of a semiconductor polycrystal silicon ingot and serve safety operation.

**Claims**

1. A silicon electro-magnetic casting apparatus that withdraws a molten silicon melted by an electro-magnetic induction and solidifies the molten silicon, being provided with: a conductive cooling crucible at least a part of which in an axial direction is segmented circumferentially into a plurality; an induction coil surrounding the crucible; and a heating means located below the crucible for gradually cooling the solidified silicon, the electro-magnetic casting apparatus being **characterized by** comprising:

a means for measuring a surface temperature of the solidified silicon at an outlet of the cooling crucible;
a means for measuring an induction frequency of an induction power source of the induction coil;
a means for controlling a power source output of the heating means, based on a measurement of the surface temperature of the solidified silicon; and
a means for controlling an output of the induction power source, based on a measurement of the induction frequency.

2. An operation method of a silicon electro-magnetic casting apparatus that withdraws a molten silicon melted by an electro-magnetic induction and solidifies the molten silicon, being provided with: a conductive cooling crucible at least a part of which in an axial direction is segmented circumferentially into a plurality; an induction coil surrounding the crucible; and a heating means located below the crucible for gradually cooling the solidified silicon, the operation method being **characterized by** comprising the steps of:

measuring a surface temperature of the solidified silicon at an outlet of the cooling crucible, and then controlling a power source output of the heating means, based on a comparison result of a measurement of the surface temperature of the solidified silicon and a preset target surface temperature;
and at the same time, measuring an induction frequency of an induction power source of the induction coil, and then controlling an output of the induction power source, based on a comparison result of a measurement of the induction frequency and a preset target induction frequency.

3. An operation method of the silicon electro-magnetic casting apparatus according to Claim 2, being **characterized in that** the power source output of the heating means and the induction frequency of the induction power source are controlled based on the most immediate three-times-measurements, even when the measurements of the surface temperature of the solidified silicon and the induction frequency are within preset target ranges.

EP 1 930 483 A1

FIG.1

FIG.2

(a)

Cooling water

(b)

Cooling water

FIG.3

Radius of ingot :R

Pulling-out speed:Vt

FIG.4

depth Zf of molten silicon(cm)

surface temperature of ingot at outlet of crucible (°C)

FIG.5

(a)

(b)

FIG.6

FIG.7

EP 1 930 483 A1

FIG.8

FIG.9

| Fix F(tgt),F(high),F(low),T(tgt),T(high),T(low) |

| Measure Fm & T(0) every 5 minutes(every 30 seconds) |

| F(low)＜Fm＜F(high) & T(low)＜T(0)＜T(high) |  Yes

No

If Fm＜F(low) or Fm＞F(high),then
D(Pm)=-(Fm-F(tgt))/F(tgt)×5000
If T(0)＜T(low) or F(0)＞T(high),then
D(Pf)=-(T(0)-T(tgt))/T(tgt)×500

18

FIG.10

surface
temperature
(°C)

induction
frequency
(Hz)

output of furnace
power source
(kW)

output of induction
power source
(kW)

| | 1263 | | | | | |
| --- | --- | --- | --- | --- | --- | --- |
| | 1260 | | | | | |
| | 1257 | | target surface | | | |
| | 1254 | | temperature | | | |
| | 1251 | | | | | |
| | 15,895 | | | | | |
| | 15,887 | | | | | |
| | 15,879 | | target frequency | | | |
| | 15,871 | | | | | |
| | 15,863 | | | | | |
| | 20 | | | | | |
| | 18 | | | | | |
| | 16 | | | | | |
| | 14 | | | | | |
| | 220 | | | | | |
| | 210 | | | | | |
| | 200 | | | | | |
| | 190 | | | | | |
| | 0 | 1 | 2 | 3 | 4 | |

casting time (Hr)

FIG.11

Fix F(tgt),F(high),F(low),T(tgt),T(high),T(low)

Measure Fm & T(0) every 1 minute

F(low)<Fm<F(high) & T(low)<T(0)<T(high)

No          Yes

If Fm(-1)-Fm(-2)>2Hz and Fm(0)-Fm(-1)>2Hz,then
D(Pm)=-1.0kW
If Fm(-1)-Fm(-2)<-2Hz and Fm(0)-Fm(-1)<-2Hz,then
D(Pm)=1.0kW
If T(0,-1)-T(0,-2)>1deg and T(0,0)-T(0,-1)>1deg,then
D(Pf)=-0.5kW
If T(0,-1)-T(0,-2)>-1deg and T(0,0)-T(0,-1)>-1deg,then
D(Pf)=0.5kW

If Fm<F(low) or Fm>F(high),then
D(Pm)=-(Fm-F(tgt))/F(tgt)×5000
If T(0)<T(low) or F(0)>T(high),then
D(Pf)=-(T(0)-T(tgt))/T(tgt)×500

FIG.12

## INTERNATIONAL SEARCH REPORT

| International application No. |
|---|
| PCT/JP2005/015132 |

| A. | CLASSIFICATION OF SUBJECT MATTER |
|---|---|
| | Int.Cl$^7$  C30B29/06, C01B33/02, C30B35/00 |

According to International Patent Classification (IPC) or to both national classification and IPC

B.  FIELDS SEARCHED

Minimum documentation searched (classification system followed by classification symbols)
Int.Cl$^7$  C30B29/06, C01B33/02, C30B35/00

Documentation searched other than minimum documentation to the extent that such documents are included in the fields searched
Jitsuyo Shinan Koho        1922-1996   Jitsuyo Shinan Toroku Koho    1996-2005
Kokai Jitsuyo Shinan Koho   1971-2005   Toroku Jitsuyo Shinan Koho    1994-2005

Electronic data base consulted during the international search (name of data base and, where practicable, search terms used)

C.  DOCUMENTS CONSIDERED TO BE RELEVANT

| Category* | Citation of document, with indication, where appropriate, of the relevant passages | Relevant to claim No. |
|---|---|---|
| A | JP 11-021120 A  (Sharp Corp.), 26 January, 1999 (26.01.99), Claim 1; Par. Nos. [0048], [0060] to [0079]; examples; Figs. 1 to 14 & US 6110274 A        & EP 0889148 B1 | 1-3 |
| A | JP 02-051493 A  (Osaka Titanium Co., Ltd.), 21 February, 1990 (21.02.90), Claim 1; page 1, right column, line 4 to page 2, upper right column, line 7; Figs. 1, 2 (Family: none) | 1-3 |

| ☒   Further documents are listed in the continuation of Box C. | ☐   See patent family annex. |
|---|---|

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered   to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| 11 November, 2005 (11.11.05) | 22 November, 2005 (22.11.05) |

| Name and mailing address of the ISA/ | Authorized officer |
|---|---|
| Japanese Patent Office | |
| Facsimile No. | Telephone No. |

Form PCT/ISA/210 (second sheet) (April 2005)

**EP 1 930 483 A1**

### INTERNATIONAL SEARCH REPORT

| International application No. |
| --- |
| PCT/JP2005/015132 |

C (Continuation). DOCUMENTS CONSIDERED TO BE RELEVANT

| Category* | Citation of document, with indication, where appropriate, of the relevant passages | Relevant to claim No. |
| --- | --- | --- |
| A | JP 03-065588 A (Komatsu Electronic Metals Co., Ltd.), 20 March, 1991 (20.03.91), Claims 1 to 4; page 3, upper right column, line 11 to page 4, upper right column, line 7 (Family: none) | 1-3 |
| A | JP 10-072300 A (Wacker Siltronic Gesellschaft fuer Halbleitermaterialien AG.), 17 March, 1998 (17.03.98), Par. Nos. [0044] to [0079] & EP 0821082 B1 | 1-3 |
| A | Kyojiro KANEKO, "Denji Cast-ho ni yoru Takessho Silicon Ingot no Renzoku Sakusei", Oyo Butsuri, 1995, Vol.64, No.7, pages 682 to 685 | 1-3 |

Form PCT/ISA/210 (continuation of second sheet) (April 2005)

**EP 1 930 483 A1**

**REFERENCES CITED IN THE DESCRIPTION**

**Patent documents cited in the description**

- JP 2660225 B
- US 4915723 A
- FR 0006027